(19) Europäisches Patentamt

European Patent Office

Office européen des brevets

(11) **EP 0 996 166 A2**

(12) **EUROPEAN PATENT APPLICATION**

(43) Date of publication:
**26.04.2000 Bulletin 2000/17**

(51) Int. Cl.$^7$: **H01L 29/15**, H01L 33/00,
H01L 29/78, H01L 31/068,
H01L 31/0304, H01S 5/343

(21) Application number: **99120755.6**

(22) Date of filing: **20.10.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.10.1998 JP 29927798**

(71) Applicant:
**Canare Electric Co., Ltd.**
**Aichi-gun, Aichi-ken 480-1101 (JP)**

(72) Inventor: **Kano, Hiroyuki**
**Nishikamo-gun, Aichi-ken 470-0201 (JP)**

(74) Representative:
**Pellmann, Hans-Bernd, Dipl.-Ing. et al**
**Patentanwaltsbüro**
**Tiedtke-Bühling-Kinne & Partner**
**Bavariaring 4**
**80336 München (DE)**

(54) **Semiconductor devices having a multiple quantum barrier structure**

(57)     A semiconductor device is constituted by a multi-period layer with plural periods of a pair of a first layer W and a second layer B. The second layer B has wider band gap than the first layer W. A δ layer, for sharply varying energy band, is formed at an every interface between the first layer W and the second layer B and has a thickness substantially thinner than the first layer W and the second layer B. By forming a δ layer, energy band gap between the first layer W and the second layer B varies sharply. As a result, a reflectivity of the multi-period layer with plural periods of a pair of a first layer W and a second layer B is improved.

FIG. 2A

FIG. 2B

FIG. 2C

FIG. 2D

EP 0 996 166 A2

**Description**

BACKGROUND OF THE INVENTION

Field of the invention

The present invention relates to a device having a multi-period layer that reflects carriers, or electrons and holes, effectively. The present invention also relates to a device having a δ layer that sharply varies the energy band. In particular, the invention relates to light-emitting semiconductor devices including a laser (LD) and a light-emitting diode (LED) with improved luminous efficiency by effectively confining carriers in an active layer. Further, the present invention relates to semiconductor devices including a field effect transistor (FET) and a solar cell with improved carrier reflectivity and improved carrier usage.

Description of the Related Art

An LD has been known to have a double hetero junction structure whose active layer is formed between n-type and p-type cladding layers. The cladding layers function as potential barriers for effectively confining carriers, or electrons and holes, within the active layer.

However, a problem persists in luminous efficiency. Carriers overflow the potential barriers of the cladding layers, which lowers luminous efficiency. Therefore, further improvement has been required, as presently appreciated by the present inventors.

As a countermeasure, forming cladding layers with a multi-quantum well structure of a first and a second layers as a unit has been suggested by Takagi et al. (Japanese Journal of Applied Physics. Vol.29, No.11, November 1990, pp.L1977-L1980). This reference, however, does not teach or suggest values of kinetic energy of carriers to be considered and the degree of luminous intensity improvement is inadequate.

SUMMARY OF THE INVENTION

The inventor of the present invention conducted a series of experiments and, from a technical problem of laminating multiple layers, he thought that the problem persists in energy band gaps existing between layers, which do not vary sharply. Accordingly, a novel multi-period layer structure was invented by the present inventor.

It is, therefore, an object of the present invention to improve a quantum-wave reflectivity by forming a δ layer, which sharply varies the energy band, in a multi-period layer with high reflectivity to carriers, functioning as a reflecting layer.

In light of these objects a first aspect of the present invention is a semiconductor device constituted by a multi-period layer having plural periods of a pair of a first layer and a second layer as a unit. The second layer has a wider band gap than the first layer. A δ layer is included for sharply varying an energy band and is formed between the first and the second layers. A thickness of the δ layer is substantially thinner than that of the first and the second layers.

The second aspect of the present invention is to use the multi-period layer as a reflecting layer for reflecting carriers.

The third aspect of the present invention is to constitute a quantum-wave incident facet in the multi-period layer by a second layer with enough thickness for preventing conduction of carriers by a tunneling effect.

The fourth aspect of the present invention is a light-emitting semiconductor device constituted by an n-type layer, a p-type layer, and an active layer that is formed between the n-type layer and the p-type layer, and wherein one of the n-type layer and the p-type layer is the multi-period layer having a δ layer between each layers described in one of the first to third aspects of the present invention.

The fifth aspect of the present invention is a light-emitting semiconductor device with a hetero-junction structure whose active layer is formed between an n-type conduction layer and a p-type conduction layer and one of the n-type and p-type conduction layers is the multi-period layer having a δ layer between each layers. The n-type and p-type conduction layers respectively function as an n-type cladding layer and a p-type cladding layer and carriers are confined into the active layer by being reflected by the multi-period layer having a δ layer between each layers.

The sixth aspect of the present invention is a field effect transistor including the multi-period layer having a δ layer between each layers, described in one of the first to third aspects of the present invention, positioned adjacent to a channel.

The seventh aspect of the present invention is a photovoltaic device having a pn junction structure including an n-layer and a p-layer. At least one of the n-layer and p-layer is made of a multi-period layer having a δ layer between each layers described in one of the first to third aspects of the present invention for reflecting minor carriers as a reflecting layer.

(first aspect of the present invention)

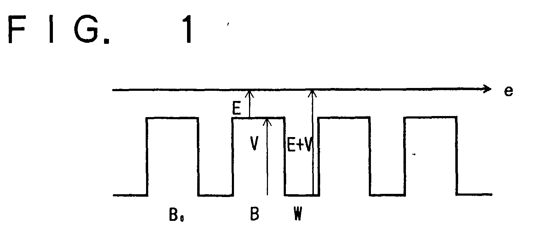

The principle of the multi-period layer having a δ layer between each layers of the present invention is explained hereinafter. FIG. 1 shows a conduction band of a multi-layer structure with plural periods of a first layer W and a second layer B as a unit. A band gap of the second layer B is wider than that of the first layer W. Electrons conduct from left to right as shown by an arrow in FIG. 1. Among the electrons, those existing around the bottom of the second layer B are likely to contribute to conduction. The electrons around the bottom of the second layer B has a kinetic energy E. Accordingly, the electrons in the first layer W have a kinetic energy E+V which is accelerated by potential energy V due to the band gap between the first layer W and the second layer B. In other words, electrons that move from the first layer W to the second layer B are decelerated by potential energy V and return to the original kinetic energy E in the second layer B. As explained above, kinetic energy of electrons in the conduction band is modulated by potential energy due to the multilayer structure.

When thicknesses of the first layer W and the second layer B are equal to order of quantum-wave wavelength, electrons tend to have characteristics of a wave. Then an interference effect of quantum-wave of electrons can be expected. Because electrons tend to have characteristics of a wave, Takagi et al. (Japanese Journal of Applied Physics. Vol.29, No.11, November 1990, pp.L1977-L1980) discloses that a multi-period layer, in which a first layer W and a second layer B are laminated under the conditions represented by the following Eqs. 1 and 2, functions as an electron reflecting layer.

$$2L_1(2m_1{}^*E_1)^{1/2}2\pi/h = (2m-1)\pi \qquad (1)$$

$$2L_2(2m_2{}^*E_2)^{1/2}2\pi/h = (2n-1)\pi \qquad (2)$$

In Eqs. 1 and 2, $L_1$ and $L_2$; $m_1{}^*$ and $m_2{}^*$; and $E_1$ and $E_2$ represents thicknesses of the first layer W and the second layer B; effective mass of electrons; and an energy of electrons, respectively. h, and m and n represents Plank's constant, and odd numbers, respectively.

Thus the conventional invention shows that with respect to a quantum-wave of conduction electrons in a certain condition, each thickness of *the first and the second* layers is determined by multiplying by odd number one fourth of quantum-wave wavelength in each of the first and the second layers. While Takagi shows multi-quantum barriers each having a band gap energy represented by $E_1$ and $E_2$ equal to 2V, respectively, the inventor of the present invention suggests a multi-period layer which functions as a reflection layer with much smaller energy than V. In short, $E_1$ and $E_2$ in Eqs. 1 and 2 is prefer to be defined as the kinetic energy of the electrons at the level near the lowest energy level of the conduction band of the second layer B. Beside, if only a multi-period layer functions as an electron reflection layer, the present invention is not necessary to be limited to the multi-period layer satisfied with the disclosed condition above.

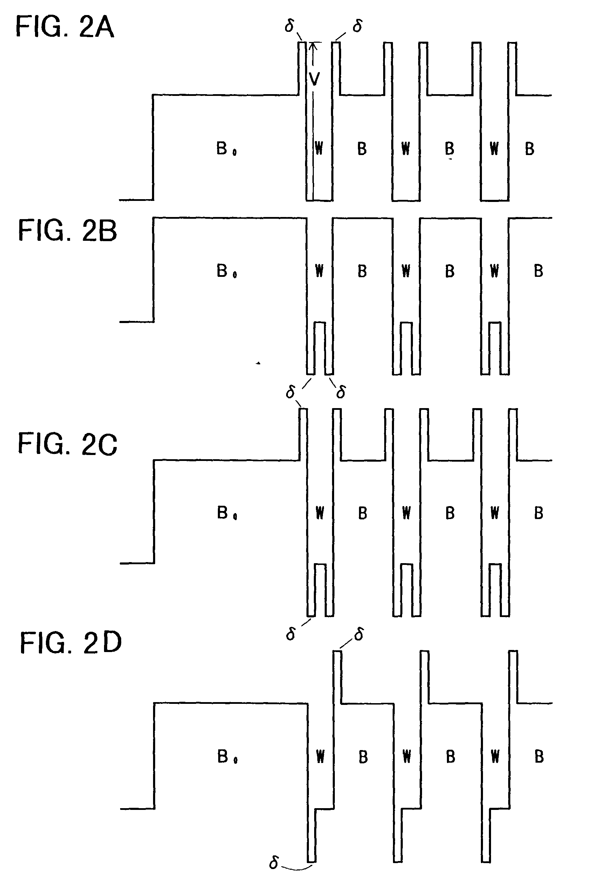

As shown in FIGS. 2A, 2B, 2C, and 2D, a δ layer is formed at the interface between the first layer W and the second layer B in the multi-period layer which functions as an electron reflecting layer. The δ layer has an adequately thinner thickness than both of the first layer W and the second layer B and sharply varies an energy band. By forming the δ layer, the potential energy V of an energy band becomes larger and a reflectivity of the interface becomes larger.

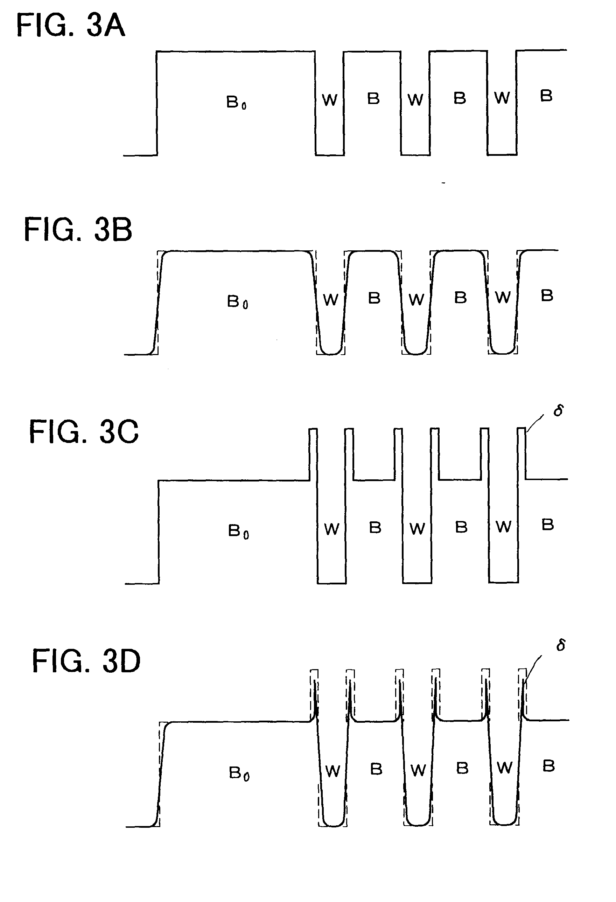

The reason why the reflectivity becomes larger can be considered as follows. Although the first layer W and the second layer B are formed so as to have the critically varying energy level as shown in FIG. 3A, actually the source gases to form one layer between the first layer W and the second layer B is mixed with the other source gases to form the other layer, when the layer to form is switched from one layer to the other. Then the energy level of the two layers loses sharpness of varying as shown in FIG. 3B. Accordingly, the first layer W and the second layer B, each having the different band width from that designed as in FIG. 3A, are formed. So, as shown in FIG. 3C, when a δ layer which has an adequately thinner thickness than both of the first layer W and the second layer B and sharply varies an energy band is formed, the multi-period layer is considered to have the energy level as shown in FIG. 3D even if the source gases are mixed. Consequently, as illustrated in FIGS. 3A and 3D, the energy level of the multi-period layer, in which a δ layer is formed at the interface between the first layer W and the second layer B, can be close to that of the multi-period layer, in which no δ layer is formed. Because the δ layers shown in FIG. 3D are substantially thin, a tunnel conduction can be expected. Although the δ layer sharply varies the energy band, motion of carriers may hardly be affected by that.

Variations are shown in FIGS. 2A to 2D. The δ layer may be formed on both ends of the every first layer W as shown in FIGS. 2A to 2C. In FIG. 2A, the δ layers are formed so that an energy level higher than that of the second layer B may be formed. In FIG. 2B, the δ layers are formed so that an energy level lower than that of the first layer W may be formed. In FIG. 2C, the δ layers are formed so that the energy level higher than that of the second layer B and the energy level lower than that of the first layer W may be formed. As an alternative to each of the variations shown in FIGS. 2A to 2C, the δ layer of FIG. 2C can be formed on one end of the every first layer W as shown in FIG. 2D.

Forming one δ layer realizes large quantum-wave reflectivity at the interface between the first layer W and the second layer B. And forming a plurality of the δ layers in a multi-period layer realizes a larger reflectivity as a whole.

(second aspect of the present invention)

The second aspect of the present invention is directed to a multi-period layer that functions as a reflecting layer and selectively confines carriers in an adjacent layer. As mentioned above, the multi-period layer can be designed to confine either electrons or holes selectively.

(third aspect of the present invention)

The third aspect of the present invention is to form a thick second layer $B_0$ at the side of an incident plane of the multi-period layer, in order to prevent conduction by tunneling effects effectively and to reflect carriers.

(fourth and fifth aspects of the present invention)

According to the fourth and the fifth aspects of the preset invention, the multi-period layer, having a $\delta$ layer at the interface of the first layer W and the second layer B, is formed in at least one of the p-type layer and an n-type layer sandwiching an active layer of a light-emitting semiconductor device and effectively realizes confinement of carriers in the active layer and increases output power.

(sixth aspect of the present invention)

According to the sixth aspect of the present invention, a multi-period layer, having a $\delta$ layer at the interface of the first layer W and the second layer B, is formed adjacent to a channel of a field effect transistor. That realizes effective confinement of carriers therein conducting through the channel so as to improve an amplification factor of the transistor and signal-to noise (S/N) ratio.

(seventh aspect of the present invention)

According to the seventh aspect of the present invention, a multi-period layer, having a $\delta$ layer at the interface of the first layer W and the second layer B, is formed in a photovoltaic device with a pn junction structure. That reflects minor carriers to the p-type or n-type layer and prevents drift of the carriers to a reverse direction around the junction, so as to improve opto-electric conversion efficiency.

BRIEF DESCRIPTION OF THE DRAWINGS

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIG. 1 is an explanatory view of a conduction band of a multi-layer structure according to the first aspect of the present invention;
FIGS. 2A to 2D are explanatory views of $\delta$ layers according to the first aspect of the present invention;
FIGS. 3A to 3D are views showing energy level according to the first aspect of the present invention;
FIG. 4 is a sectional view showing a first exemplary structure of a light-emitting diode 100 in Example 1;
FIGS. 5A and 5B are views showing energy diagrams of the LED in Examples 1 and 2;
FIG. 6 is a graph showing the relationship between thickness of a $\delta$ layer and luminous intensity in Example 2;
FIG. 7 is a sectional view showing a second exemplary structure of a light-emitting diode 300 in Example 2;
FIGS. 8A and 8B are views showing energy diagrams of the LED in Example 3;
FIG. 9 is a view showing a structure of MOSFET in Example 4;
FIG. 10 is a view showing an energy diagram of the MOSFET in Example 4; and
FIG. 11 is a view showing the energy diagram of the photovoltatic device in Example 5.

DETAILED DESCRIPTION OF THE PREFERRED EMBODIMENTS

The invention will be more fully understood by reference to the following examples.

Example 1

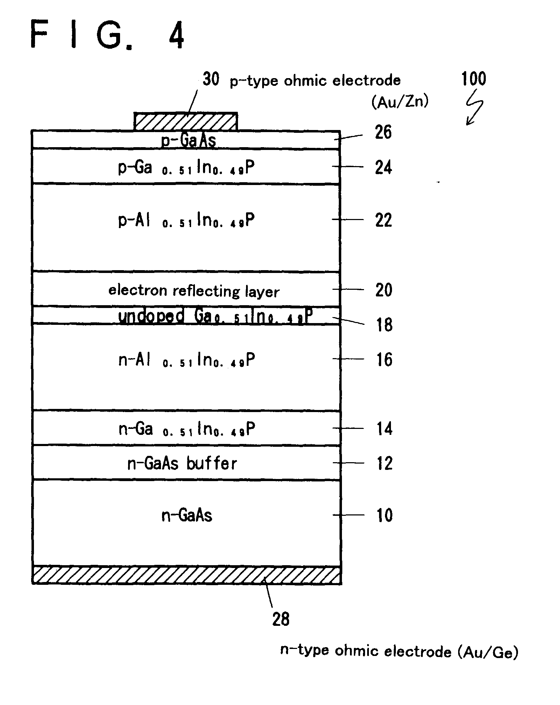

FIG. 4 is a sectional view of a light-emitting diode (LED) 100 in which a multi-period layer having a $\delta$ layer between each layers is formed in a p-type cladding layer. The LED 100 has a substrate 10 made of gallium arsenide (GaAs). An n-GaAs buffer layer 12 having a thickness generally of 0.3 $\mu$m and an electron concentration of $2 \times 10^{18}/cm^3$ is formed on the substrate 10. An n-$Ga_{0.51}In_{0.49}P$ contact layer 14 of n-type conduction, having a thickness generally of 0.3 $\mu$m and electron concentration of $2 \times 10^{18}/cm^3$, is formed on the buffer layer 12. An n-$Al_{0.51}In_{0.49}P$ cladding layer 16 of n-type conduction, having a thickness generally of 1 $\mu$m and an electron concentration of $1 \times 10^{18}/cm^3$, is formed on the n-contact layer 14. A non-doped $Ga_{0.51}In_{0.49}P$ emission layer 18 having a thickness generally of 14 nm is formed on the n-cladding layer 16. An electron reflecting layer 20 of a multi-period layer having a $\delta$ layer between each layers is formed on the emission layer 18. A p-$Al_{0.51}In_{0.49}P$ cladding layer 22 of p-type conduction, having a thickness generally of 1 $\mu$m and a hole concentration of $1 \times 10^{18}/cm^3$, is formed on the electron reflecting layer 20. A p-$Ga_{0.51}In_{0.49}P$ second contact layer 24 of p-type conduction, having a thickness generally of 0.2 $\mu$m and a hole concentration of $2 \times 10^{18}/cm^3$, is formed on the p-type cladding layer 22. A p-GaAs first contact layer 26 of p-type conduction, having a thickness generally of 0.1 $\mu$m, is formed on the second p-type contact layer 24. An electrode layer 28 made of gold and germanium (Au/Ge), having a thickness generally of 0.2 $\mu$m, is

formed so as to cover the entire back of the substrate 10. Another electrode layer 30 made of gold and zinc (Au/Zn), having a thickness *generally* of 0.2 μm, is formed on some portion of the first contact layer 26. The substrate 10 has a diameter of 2.0 inches and the normal direction of its main surface is offset toward the [011] axis by 15 degree from the (100) plane.

The LED 100 was manufactured by gas source molecular beam epitaxial deposition (GS-MBE), which is an epitaxial growth method performed under extremely a high vacuum condition. GS-MBE is different from a conventional MBE, which supplies group III and V elements both from the solid sources. In GS-MBE, group III elements such as indium (In), gallium (Ga), and aluminum (Al) are supplied from a solid source and group V elements such as arsenic (As) and phosphorus (P) are supplied by heat decomposition of gas material such as $AsH_3$ and $PH_3$. Alternatively, the LED 100 can be manufactured by metal organic chemical vapor deposition (MOCVD).

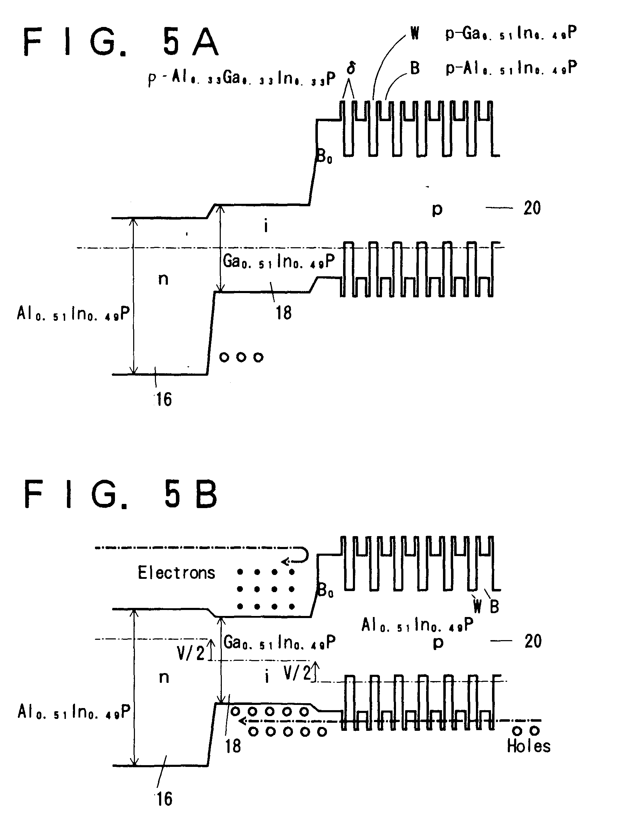

In the energy diagrams of FIGS. 5A and 5B, the n-type cladding layer 16, the emission layer 18, and the electron reflecting layer 20 are shown. FIG. 5A shows an energy level of conduction and valence bands on the condition that no external voltage is applied to the LED 100, and FIG. 5B shows the energy level on the condition that the external voltage is applied thereto. The electron reflecting layer 20, or a multi-period layer having δ layers, has a multi-quantum layer structure with 15 periods of a $p\text{-}Ga_{0.51}In_{0.49}P$ well layer as a first layer W and a $p\text{-}Al_{0.51}In_{0.49}P$ barrier layer as a second layer B. A δ layer made of $p\text{-}Al_{0.33}Ga_{0.33}In_{0.33}P$ is formed at each interface between the first layer W and the second layer B. Only the first second layer $B_0$ is designed to have enough thickness to prevent conduction of carriers by tunneling effects. The δ layer is formed to have a thickness of 1.3 nm.

Accordingly, electrons injected from the n-type cladding layer 16 into the emission layer 18 are reflected effectively by the electron reflecting layer 20 and confined into the emission layer 18. Although the valence band of the electron reflecting layer 20 also has a multiple period of energy level, holes are designed not to be reflected thereby. The respective thickness of the first layer W and the second layer B in the reflecting layer 20 is designed to reflect electrons only. Therefore, holes injected from the p-type cladding layer 22 pass through the electron reflecting layer 20 thus reaching the emission layer 18 easily and being confined therein by the cladding layer 16. The luminous output of LED 100 was measured to be eightfold compared to that of an LED having no electron reflecting layer.

Example 2

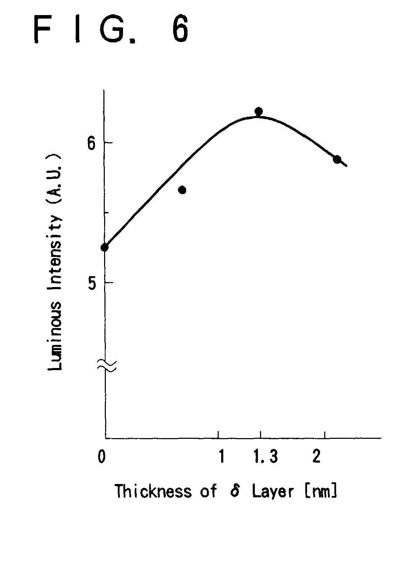

In this embodiment, an LED has a structure as same as that of the LED of FIG. 5. A thickness of the δ layer is varied in many samples and a measured luminous intensity of the LED for the various thicknesses is shown in FIG. 6. The luminous intensity reaches its peak when the thickness of the δ layer is about 1.3 nm while the thickness of the first layer W and the second layer B are 5.6 nm and 7.5 nm, respectively. The obtained luminous intensity of the LED 200 was 1.5 fold of that of an LED without the δ layer.

Example 3

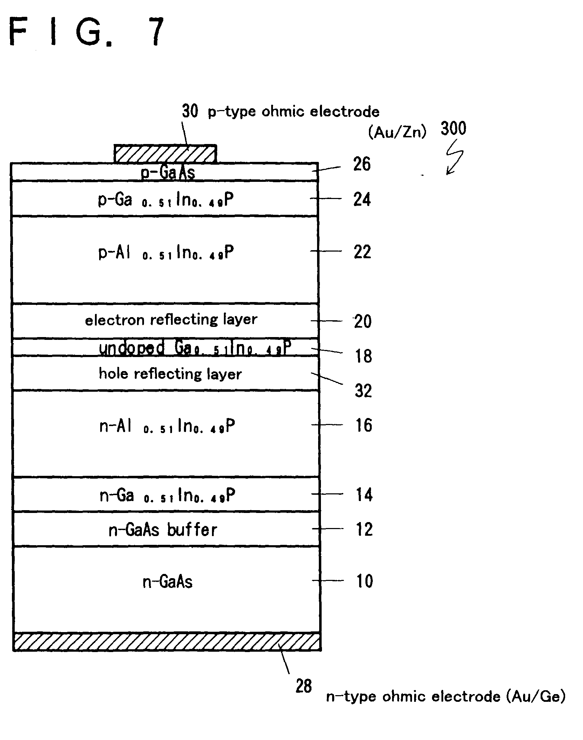

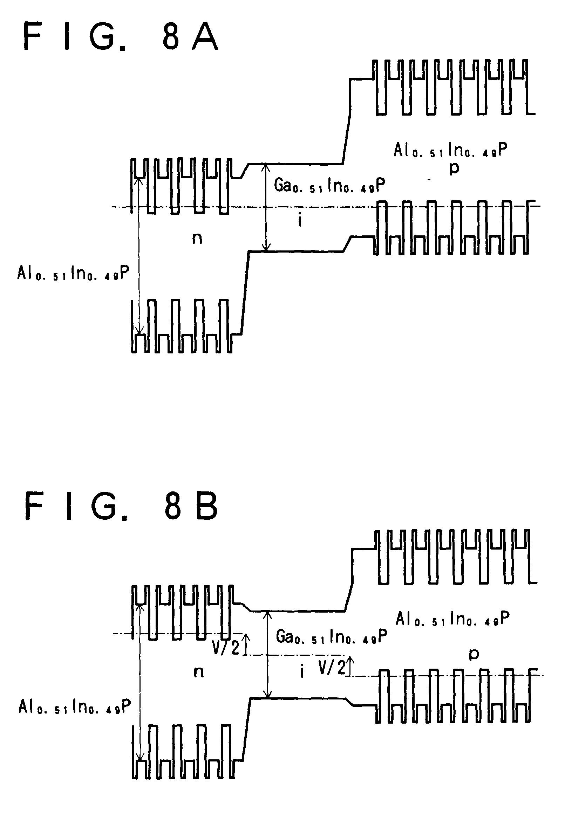

FIG. 7 shows an LED 300 used in the present embodiment. The LED 300 has a hole reflecting layer 32 additionally to the LED 100 structure for reflecting holes. The hole reflecting layer 32 is formed between an n-type cladding layer 16 and an emission layer 18 and has a same structure except for the thickness of each layers as the electron reflecting layer 20 of the LED 100. The thickness of the first layer W is 1.0 nm and that of the second layer B is 1.2 nm. FIG. 8A shows an energy level of conduction and valence bands on the condition that no external voltage is applied to the LED 300 and FIG. 8B shows a condition where the external voltage is applied thereto. As a result, the LED 300 thus obtained provides a luminous intensity of 16 fold compared with an LED with as same structure as the LED 300 but without the electron reflecting layer 20 and the hole reflecting layer 32, each of which is a multi-period layer having a δ layer between each layers.

Example 4

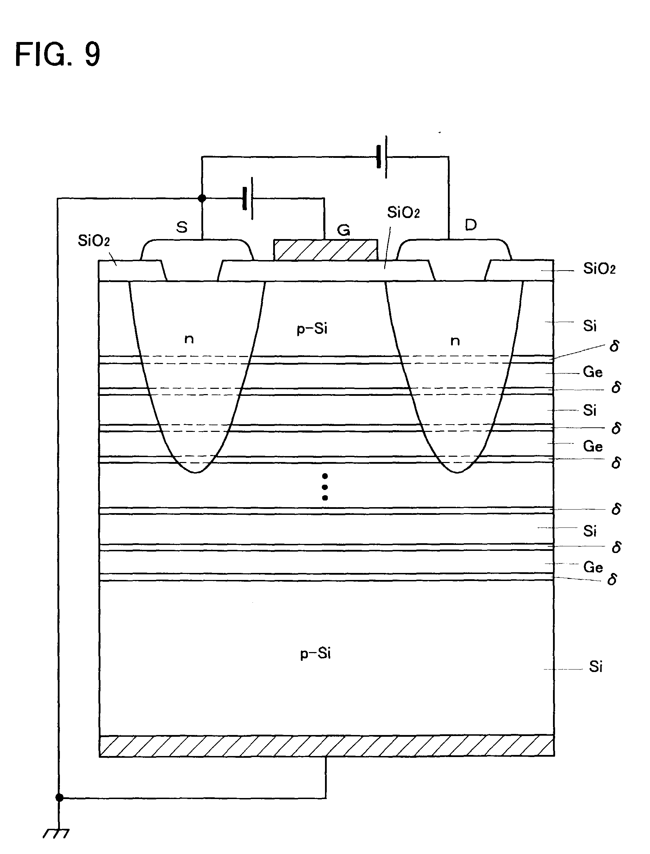

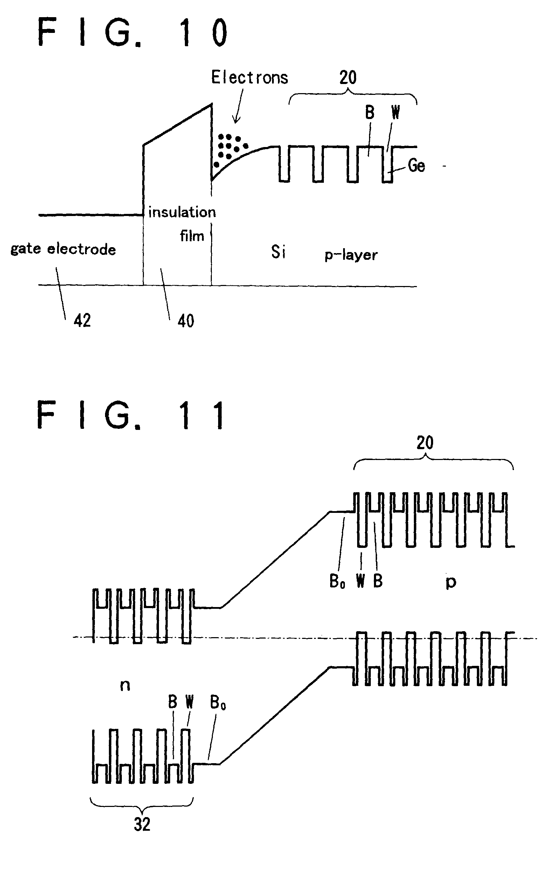

FIG. 10 is an energy diagram of a MOSFET according to the present embodiment. A conventional MOSFET has a channel of an inversion layer just beneath an insulation film 40, conducting minority carriers through the channel. A larger voltage is applied to a gate electrode 42 of the conventional MOSFET and thus more carriers in the channel of the inversion layer overflow. As a result, signal-to-noise (S/N) ratio decreases. In order to solve the problem, a multi-period layer 20 having a δ layer between each layers was formed beneath the channel as shown in FIG. 9 having a multi-layer structure with arbitrary periods including the second layer B made of silicon (Si) and the first layer W made of germanium (Ge). As a result, more carriers were confined in the channel of the inversion layer. In addition, S/N ratio was improved, response time was shortened, and driving voltage was lowered. When an n-type channel and electrons as a carrier were used, the most preferable thickness of the second layer B was 6.8 nm and that of the first layer W was 2.0 nm.

Example 5

A multi-period layer having a δ layer between each layers can be formed in a photovoltaic device with a pn junction structure. As shown in FIG. 11, an electron reflecting layer 20 is formed in a p-layer, and a hole reflecting layer 32 is formed in an n-layer. When light is incided on the pn junction of a conventional device without the reflecting layers 20 and 32, pairs of an electron and a hole are generated. Most of the electrons in the conventional device are accelerated to the n-layer due to potential declination of conduction bands while the rest of the electrons drift to the p-layer so as not to contribute to induction of voltage. The larger the intensity of the incident light becomes, the more electrons overflow to the p-layer. Accordingly, the electron reflecting layer 20, or a multi-period layer having a $\delta$ layer between each layers, was formed in the p-layer in this embodiment. As a result, drifting of electrons were prevented, which enabled more electrons to conduct to the n-layer. Similarly, some of holes do not contribute to induction of voltage on account of holes drifting to the n-layer in a conventional device. Accordingly, in this embodiment the hole reflecting layer 32, or a multi-period layer having a $\delta$ layer between each layers, was formed in the n-layer. As a result, drifting of holes were prevented and enabled more holes to conduct to the p-layer. Consequently, leakage of current was minimized and efficiency of electro-optic convention was improved.

In the present invention, embodiments of LEDs with multi-period layers having a $\delta$ layer between each layers are shown and discussed in Examples 1-5. Alternatively, the multi-period layer having a $\delta$ layer between each layers can be applied to a laser diode.

Further, in Examples 1-5, the multi-period layer and the $\delta$ layer was made of ternary compounds including $Ga_{0.51}In_{0.49}P$ and $Al_{0.51}In_{0.49}P$, and quaternary compounds including $Al_{0.33}Ga_{0.33}In_{0.33}P$, respectively. Alternatively, the multi-period layer having a $\delta$ layer between each layers can be made of quaternary compounds such as $Al_xGa_yIn_{1-x-y}P$ or $Al_xGa_yIn_{1-x-y}As$, selecting arbitrary composition ratio within the range of $0 \leq x \leq 1$, $0 \leq y \leq 1$, and $0 \leq x+y \leq 1$.

As another alternative, the multi-period layer can be made of group III-V compound semiconductor, group II-VI compound semiconductors, Si and Ge, and semiconductors of other hetero-material. The desirable compositions are as follows. Each combinations is represented by a composition of a layer having a wide band width / a layer having a narrow band width // a substrate. And x and y are arbitrary values wherein $0 \leq x \leq 1$ and $0 \leq y \leq 1$, as long as they are not specified.

〈1〉 $Al_xIn_{1-x}P$ / $Ga_yIn_{1-y}P$ // GaAs
〈2〉 $Al_xGa_{1-x}As$ / GaAs // GaAs
〈3〉 $Ga_xIn_{1-x}P$ / InP // InP
〈4〉 $Ga_xIn_{1-x}P$ / $Ga_xIn_{1-x}As$ // GaAs
〈5〉 AlAs / $Al_xGa_{1-x}As$ // GaAs ($0.8 \leq x \leq 0.9$)
〈6〉 InP / $Ga_xIn_{1-x}As_yP_{1-y}$ // GaAs
〈7〉 Si / $SiGe_x$ // arbitrary material ($0.1 \leq x \leq 0.3$)
〈8〉 Si / $SiGe_xC_y$ // arbitrary material ($0.1 \leq x \leq 0.3$, $0 < y \leq 0.1$)
〈9〉 $Al_{x1}Ga_{y1}In_{1-x1-y1}N$ / $Al_{x2}Ga_{y2}In_{1-x2-y2}N$ // Si, SiC, GaN, or sapphire ($0 \leq x_1$, $x_2$, $y_1$, $y_2$, $x_1+y_1$, $x_2+y_2 \leq 1$)

While the invention has been described in connection with what are presently considered to be the most practical and preferred embodiments, it is to be understood that the invention is not to be limited to the disclosed embodiments, but on the contrary, the description is intended to cover various modifications and equivalent arrangements included within the spirit and scope of the appended claims. The present document claims the benefit of Japanese priority document, filed in Japan on October 21, 1998, the entire contents of which is incorporated herein by reference.

Obviously, numerous modifications and variations of the present invention are possible in light of the above teachings. It is therefore to be understood that within the scope of the appended claims, the invention may be practiced otherwise than as specifically described herein.

A semiconductor device is constituted by a multi-period layer with plural periods of a pair of a first layer W and a second layer B. The second layer B has wider band gap than the first layer W. A $\delta$ layer, for sharply varying energy band, is formed at an every interface between the first layer W and the second layer B and has a thickness substantially thinner than the first layer W and the second layer B. By forming a $\delta$ layer, energy band gap between the first layer W and the second layer B varies sharply. As a result, a reflectivity of the multi-period layer with plural periods of a pair of a first layer W and a second layer B is improved.

**Claims**

1. A semiconductor device comprising:

   a multi-period layer having;
   plural periods of a pair of a first layer and a second layer, said second layer having a wider band gap than said first layer; and
   a $\delta$ layer for sharply varying energy band, being formed between said first and said second layers.

2. A semiconductor device according to claim 1, wherein said multi-period layer functions as a reflecting layer for reflecting carriers.

3. A semiconductor device according to claim 1, wherein an incident plane of quantum-wave in said multi-period layer is said second layer having enough thickness to prevent conduction of carriers by a tunneling effect.

4. A semiconductor device according to claim 2, wherein an incident plane of quantum-wave in said multi-period layer is said second layer having enough thickness to prevent conduction of carriers by a tunneling effect.

5. A light-emitting semiconductor device having a multi-period layer of claim 1 and further comprising:

an n-type layer;
a p-type layer;
an active layer formed between said n-type layer and said p-type layer; and
wherein one of said n-type layer and said p-type layer has said multi-period layer having a δ layer between each layers .

6. A light-emitting semiconductor device having a multi-period layer of claim 2 and further comprising:

an n-type layer;
a p-type layer;
an active layer formed between said n-type layer and said p-type layer; and
wherein one of said n-type layer and said p-type layer has said multi-period layer having a δ layer between each layers .

7. A light-emitting semiconductor device having a multi-period layer of claim 3 and further comprising:

an n-type layer;
a p-type layer;
an active layer formed between said n-type layer and said p-type layer; and
wherein one of said n-type layer and said p-type layer has said multi-period layer having a δ layer between each layers .

8. A light-emitting semiconductor device according to claim 5, wherein said n-layer and/or said p-layer form a hetero-junction to said active layer respectively functioning as an n-type cladding layer and a p-type active layer by being reflected by said multi-period layer.

9. A light-emitting semiconductor device according to claim 6, wherein said n-layer and/or said p-layer form a hetero-junction to said active layer respectively functioning as an n-type cladding layer and a p-type active layer by being reflected by said multi-period layer.

10. A light-emitting semiconductor device according to claim 7, wherein said n-layer and/or said p-layer form a hetero-junction to said active layer respectively functioning as an n-type cladding layer and a p-type active layer by being reflected by said multi-period layer.

11. A field effect transistor comprising a multi-period layer having a δ layer between each layers of claim 1 formed adjacent to a channel.

12. A field effect transistor comprising a multi-period layer having a δ layer between each layers of claim 2 formed adjacent to a channel.

13. A field effect transistor comprising a multi-period layer having a δ layer between each layers of claim 3 formed adjacent to a channel.

14. A photovoltaic device having a pn junction including an n-layer and a p-layer comprising at least one of said n-layer ad said p-layer having a multi-period layer of claim 1 for reflecting minor carriers as a reflecting layer.

15. A photovoltaic device having a pn junction including an n-layer and a p-layer comprising at least one of said n-layer ad said p-layer having a multi-period layer of claim 2 for reflecting minor carriers as a reflecting layer.

16. A photovoltaic device having a pn junction including an n-layer and a p-layer comprising at least one of said n-layer ad said p-layer having a multi-period layer of claim 3 for reflecting minor carriers as a reflecting layer.

# F I G. 1

## FIG. 2A

## FIG. 2B

## FIG. 2C

## FIG. 2D

## FIG. 3A

## FIG. 3B

## FIG. 3C

## FIG. 3D

# F I G. 4

30 p-type ohmic electrode     **100**
(Au/Zn)

| | |
|---|---|
| p-GaAs | — 26 |
| p-Ga $_{0.51}$In$_{0.49}$P | — 24 |
| p-Al $_{0.51}$In$_{0.49}$P | — 22 |
| electron reflecting layer | — 20 |
| undoped Ga$_{0.51}$In$_{0.49}$P | — 18 |
| n-Al $_{0.51}$In$_{0.49}$P | — 16 |
| n-Ga $_{0.51}$In$_{0.49}$P | — 14 |
| n-GaAs buffer | — 12 |
| n-GaAs | — 10 |

28

n-type ohmic electrode (Au/Ge)

# F I G. 5 A

$p-Al_{0.33}Ga_{0.33}In_{0.33}P$    $\delta$

W   $p-Ga_{0.51}In_{0.49}P$

B   $p-Al_{0.51}In_{0.49}P$

$B_0$

i

p   — 20

$Ga_{0.51}In_{0.49}P$

$Al_{0.51}In_{0.49}P$

n

18

o o o

16

# F I G. 5 B

Electrons · · · ·

$B_0$

W B

$Al_{0.51}In_{0.49}P$

p   — 20

V/2↕   $Ga_{0.51}In_{0.49}P$

n

i   V/2↕

$Al_{0.51}In_{0.49}P$

o o o o o

18   o o o o o

Holes   o o

16

# F I G.  6

# F I G. 7

30 p-type ohmic electrode
(Au/Zn) 300

| | |
|---|---|
| p-GaAs | — 26 |
| p-Ga $_{0.51}$In$_{0.49}$P | — 24 |
| p-Al $_{0.51}$In$_{0.49}$P | — 22 |
| electron reflecting layer | — 20 |
| undoped Ga$_{0.51}$In$_{0.49}$P | — 18 |
| hole reflecting layer | — 32 |
| n-Al $_{0.51}$In$_{0.49}$P | — 16 |
| n-Ga $_{0.51}$In$_{0.49}$P | — 14 |
| n-GaAs buffer | — 12 |
| n-GaAs | — 10 |

28 n-type ohmic electrode (Au/Ge)

FIG. 8A

$Al_{0.51}In_{0.49}P$
p

$Ga_{0.51}In_{0.49}P$

i

$Al_{0.51}In_{0.49}P$

n

FIG. 8B

$Al_{0.51}In_{0.49}P$

$Ga_{0.51}In_{0.49}P$

V/2↑

n

i V/2↑

p

$Al_{0.51}In_{0.49}P$

# FIG. 9

# F I G. 1 0

Electrons 20

B W

insulation
film

Ge

gate electrode

Si p-layer

42 40

# F I G. 1 1

20

B₀ W B p

n

B W B₀

32